# EUROPEAN PATENT APPLICATION

(11) **EP 0 902 102 A1**
(43) Date of publication of application: **17.03.1999**
(21) Application number: 98116213.4
(22) Date of filing: 27.08.1998
(51) Int. Cl.: C23C 14/14

(54) **Ta sputtering targets, method of manufacturing the same, and assemblies**

(30) Priority: 10.09.1997 JP 261108/97
(71) Applicant: JAPAN ENERGY CORPORATION, Minato-ku, Tokyo (JP)
(72) Inventor: Kano, Osamu c/o Isohara Plant, Japan Energy Corpo., Kitaibaraki-shi, Ibaraki-ken (JP); Irumata, Shuichi Isohara Plant, Japan Energy Corpo, Kitaibaraki-shi, Ibaraki-ken (JP)
(74) Representative: Schwan, Gerhard, Dipl.-Ing.

(57) **Abstract**

Inexpensive Ta sputtering targets which permit deposition of Ta and TaNₓ films with fewer particles and less dispersion of resistivity values. Ta targets having an average grain size of 0.1-300 µm,with dispersion within± 20%, an oxygen content of 50ppm or below and containing Na≦ 0.1ppm, K≦ 0.1ppm, U≦ 1ppb, Th≦ 1ppb, Fe≦ 5ppm, Cr≦ 5ppm, and Ni≦ 5ppm, the total content of refractory metal elements be ing 50ppm or less. Preferably, the sum of the intensity ratios of the three planes {110}, {200} and {211} is 55% or more, with dispersion of± 20% or less, the hydrogen concentration is 20 ppm or less, the average roughness (Ra) of the surface portion to be sputtered is 0.01-5 µm, and an oxide layer with a thickness of 200 nm or less, and the target portions where a film is formed by the deposition of the sputtered target material is roughened. A method of manufacturing a Ta target and target assembly are also disclosed.

## Description

### [BACKGROUND OF THE INVENTION]

This invention relates to Ta sputtering targets, a method of manufacturing the same, and target assemblies. Particularly, this invention relates to Ta sputtering targets for depositing a Ta film or TaN film as a diffusion barrier layer for the electrodes and wirings or interconnections of large-scale integration circuits; a method of manufacturing the targets; and target-backing plate assemblies.

Al and Al alloys have hitherto been used as materials for the electrodes and wirings of LSI circuits. The recent tendency toward higher degrees of integration has promoted the study of replacing them by Cu that has greater resistance to electromigration (EM) and stress migration (SM). However, Cu must be surrounded by a diffusion barrier layer because otherwise Cu would diffuse easily in SiO that is used as an interlayer insulation layer. The barrier layer used for this purpose has been that of TiN deposited using a Ti target by reactive sputtering in nitrogen. More recently, a Ta film deposited from a Ta target and a TaN film formed using a Ta target by reactive sputtering in nitrogen have attracted attention because of their superiority in thermal stability and barrier properties.

The present inventors once attempted to form Ta and TaN layers using some commercially available Ta targets. The wafers on which the layers were deposited showed the presence of many objectionable particles, and the Ta and TaN films had high sheet resistivities with rather wide dispersions. Thus, despite the superiority to TiN in barrier properties, the Ta and TaN films were not put to practical use.

Moreover, it is not known yet what is the purity required of Ta and TaN films as diffusion barrier layers. For example, Japanese Patent Application Publication (Kokoku) No. 6-21346 discloses a method of decreasing refractory metal element contents to 3 ppm or less by a wet refining process which depends on precipitation of potassium tantalum fluoride crystals and reduction of the crystals with sodium. From the industrial viewpoint the extra refining process increases the cost to a not negligible extent.

### [OBJECT OF THE INVENTION]

As described above, the deposition of Ta and TaN films using the conventional Ta targets entails the generation of many objectionable particles. In addition, the films possess high sheet resistivities with rather wide dispersions. A special refining process cannot be adopted without a cost increase that is not industrially justified.

The present invention has for its object to solve those problems of the prior art.

### [SUMMARY OF THE INVENTION]

Investigations have been made about the possible causes of the generation of many particles upon deposition of Ta and TaN films by use of conventional Ta targets. As a result it has now been found that the prior art targets range in average grain size from 400 to 500 µm and the large grain size is partly responsible for the generation of a lot of particles. It has also been found that decreasing the number of oxide grains in the target helps control the particle generation. The study has further revealed that in order to lower the sheet resistivity of the deposited film it is advisable to minimize the oxygen content and in order to restrict the dispersion of the sheet resistivity it is effective to limit the dispersion of the grain size. It has been confirmed that the contents of the impurities of alkali metals, radioactive elements and transition metals, in Ta and TaN films are just enough if they meet the levels required in the semiconductor targets. Refractory metal elements, if present to excess, would raise the sheet resistivities of Ta and TaN films. For diffusion barrier applications, it has been confirmed that the presence of those elements does not present any problem unless the total amount exceeds 50 ppm and refining down to less than 3 ppm is not necessary. Thus it has just been found that Ta targets can be manufactured without going through a wet refining process as taught by Patent Application Kokoku No. 6-21346 that has a disadvantage of industrially prohibitive cost.

In light of the foregoing, this invention provides (1) a Ta sputtering target characterized by (a) an average grain size of 0.1-300 µm, with locational dispersion of the average grain size within ± 20%, (b) an oxygen concentration of 50 ppm or below, and (c) impurity concentrations such that Na ≦ 0.1 ppm, K ≦ 0.1 ppm, U ≦ 1 ppb, Th ≦ 1 ppb, Fe ≦ 5 ppm, Cr ≦ 5 ppm, and Ni≦ 5 ppm, the total content of refractory metal elements (Hf, Nb, Mo, W, Ti, and Zr) being 50 ppm or less.

In connection with the rate of film deposition, the present inventors have found that the deposition rate is improved by controlling the orientation of the target so that the sum of the area ratios to the sputtered surface of the three planes {110}, {200} and {211} where atomic density is high should be 55% or more. We have also found that the uniformity of film quality in a wafer is maintained by restricting the dispersion of the sum of the area ratios of these three planes in the target surface within ± 20%.

In view of this, this invention provides (2) a Ta sputtering target as defined above and characterized in that the sum of the intensity ratios of the three planes {110}, {200} and {211} is 55% or more and the locational dispersion of the sum of the intensity ratios of the three planes is 20% or less.

Many particles are formed as the TaN film deposited on the components and surrounding walls of a sputtering apparatus comes off. To prevent this, a process known as "pasting" whereby a Ta film as a past is beforehand formed on such components and walls is usually used. However, when the Ta film contains hydrogen atoms, the film stresses can be so high that the Ta/TaN films tend to become loose and fall, which leads to the increase of particle number. The present inventors have found that limiting the hydrogen concentration in a target to 20 ppm or less helps decrease the number of particles to a level negligible for the practical purposes.

Thus, this invention further provides (3) a Ta sputtering target as defined above and characterized in that its hydrogen concentration is 20 ppm or less.

In the early stage of target sputtering, a large number of particles emerges as a surface damage layer that has been damaged by mechanical surface finishing is sputtered. The present inventors have found that, with Ta targets, the damaged surface layer can be lessened by decreasing the average roughness (Ra) after the surface finish.

This invention also provides (4) a Ta sputtering target as defined above and characterized in that the average roughness (Ra) of the surface portion to be sputtered is 0.01-5 µm.

An oxide layer formed on the surface of a target causes abnormal discharge, which in turn is responsible for an increase in the number of particles. The present inventors have found that when the thickness of an oxide layer of a Ta target is controlled to 200 nm or less, the abnormal discharge in the early stage of sputtering is suppressed with the decrease of particle number.

Hence this invention provides (5) a Ta sputtering target as defined above and characterized in that the surface portion to be sputtered has an oxide layer with a thickness of 200 nm or less.

With the progress of sputtering, the portions of the target other than the area being eroded allow the deposition of a Ta layer or TaN layer. As it attains more than a given thickness, the deposited film tends to come off, giving birth to particles. The present inventors have found that roughening the non-eroded surface portions of a Ta target that are exposed in a sputtering chamber produces an anchoring effect which makes a re-deposited film more adherent and thereby decreases the number of particles.

The invention then provides (6) a Ta sputtering target as defined above and characterized in that the non-eroded surface portions of a target where a film is formed by the deposition of the sputtered target material is roughened.

In relation to the manufacturing, this invention provides a method of manufacturing a Ta sputtering target as defined in (1) above which comprises making a Ta ingot which has an oxygen concentration of 50 ppm or below and impurity concentrations such that Na≦ 0.1 ppm, K≦ 0.1 ppm, U≦ 1 ppb, Th≦ 1 ppb, Fe≦ 5 ppm, Cr≦ 5 ppm and Ni≦ 5 ppm, the total content of refractory metal elements (Hf, Nb, Mo, W, Ti and Zr) being 50 ppm or less, working the ingot by cold forging or/and cold rolling, and finally machining the workpiece obtained to a target, characterized in that, in the course of working of the cold forging or/and cold rolling, the workpiece is heat treated in a vacuum at a heating rate of at least 10 °C/min and at a holding temperature of 800-1200 °C whereby the material attains an average grain size of 0.1-300 µm with locational dispersion within ± 20%.

In another aspect this invention provides a Ta sputtering target assembly characterized by comprising a Ta sputtering target as defined above and a backing plate bonded to the target.

It is desirable that the portion of the backing plate where the sputtered material is to deposit and form a film thereon is roughened on the surface.

For sputtering with a high power output, it is advisable that the Ta sputtering target and the backing plate are bonded by a metallic bond.

### [DETAILED EXPLANATION OF THE INVENTION]

With the steady increase in the degree of large-scale integration, the use of Cu that is outstandingly resistant to electromigration (EM) and stress migration (SM) is being studied as a material for the electrodes and wirings of LSIs. For that application Cu must be surrounded by a diffusion barrier layer, and as the barrier attention is now focused on a Ta layer deposited from a Ta target and a more thermally stable TaNₓ (x = 0.5-1.3) layer formed using a Ta target by reactive sputtering in nitrogen. With existing Ta targets, however, particle generation is large and the resulting films show high sheet resistivities with wide variations of the resistivity values.

For the reduction of particle generation number during sputtering, both crystal grain refinement of the target and diminution in the presence of oxide particle inclusions in the target are effective. For the decrease in the sheet resistivity after film deposition, the least possible oxygen content is desirable. Further, restricting the locational dispersion of grain size, e.g., between the central and peripheral regions, effectively lessens the dispersion of sheet resistivity. It is important that the average grain size should be 0.1-300 µm and the locational dispersion of the average grain size be within± 20%. The oxygen concentration should be 50 ppm or less. Under this invention it is possible to realize a Ta film resistivity of 270 µΩcm or below and a dispersion of resistivity (σ) in a wafer, in terms of 3σ, of 3σ ≦ 4.5%.

Refinement of the crystal grain size is achieved by optimizing the temperature and time for the heat treatment after cold forging or cold rolling. In brief, it is realized by increasing the working ratio of cold forging or cold rolling, rapidly heating the workpiece, for the ensuing heat treatment, to the lowest possible temperature above the temperature at which recrystallization takes place, and cooling the workpiece before the grains coarsen beyond the necessary size. Compared with cold forging, cold rolling is easier to attain a uniform amount of working and therefore cold rolling is preferred when the dispersion of the grain size is to be restricted. A heat treatment in the course of cold forging or/and cold rolling, in a vacuum at a heating rate of at least 10 °C/min. and at a holding temperature of 800-1200 °C is recommended.

To reduce the particle production, the oxygen content must at most be below the solid solution limit of oxygen in Ta at the heat treatment temperature. Also, as noted above, the lowest possible oxygen content is desired for the decrease of sheet resistivity after film deposition. As to the amounts of impurities of alkali metals, radioactive elements and transition metals in Ta and TaN films, they are enough as long as they just satisfy the impurity concentration levels of a semiconductor target. In the case of Ta it is difficult to decrease the concentrations of oxygen and impurities in any step after ingot making. Therefore, an ingot must be used which initially satisfies the requirements; an oxygen content of 50 ppm or less and impurity contents required of a semiconductor target, i.e., Na≦ 0.1 ppm, K≦ 0.1 ppm, U≦ 1 ppb, Th≦ 1 ppb, Fe≦ 5 ppm, Cr≦ 5 ppm, and Ni≦ 5 ppm. Diminution of the impurity concentrations is realized by melting a commercially available high-purity Ta powder by electron beam melting. Refractory metal elements, if present to excess, would raise the sheet resistivities of Ta and TaN films. Hence a total of 50 ppm is specified to be the upper limit. For the application as a diffusion barrier, the presence of such metal elements causes no problem when the combined amount is below that upper limit, and refinement to less than 3 ppm is not particularly necessary. Refinement to less than 3 ppm is found effective at diminishing leakage current in an application as a capacitor material where electric charge is to be built up, but there is no such necessity for the diffusion barrier application. Thus, a Ta target of the purity at which this invention is aimed can be manufactured by mere electron beam melting of a commercially available high-purity Ta powder, without adopting the wet refining process as taught in Patent Application Kokoku No. 6-21346 that has the disadvantage of too high cost for industrial operation.

An ingot of the impurity concentrations specified above was worked (cold forged, cold rolled) and heat treated to make a target having a grain size of 150 µm and an oxygen concentration of 20 ppm, and Ta and TaN films were deposited using the target. The number of particles was dramatically decreased as compared that produced using a target with an average grain size of 500 µm.

When a starting ingot having a grain size of no less than 1 mm obtained by electron beam melting or the like is uniaxially cold forged/cold rolled, coarse grains of the starting ingot remain unremoved even after a heat treatment. Sputtering with the resulting target forms protuberant deposits known as "nodules" along the grain boundary between coarse grains, and these nodules serve as a source to generate particles, thus increasing the number of particles caused on the wafer. In order to eliminate the coarse grains, it is necessary to effect plastic deformation of the workpiece by forging it in biaxial or more multiaxial directions, e.g., by combining compressing and upsetting forgings.

For working in the thickness direction, the rolling method that can introduce an even amount of reduction is more suitable. However, the rolling method has a limitation in the workable thickness; it can hardly work an ingot having a thickness greater than the width in the intended directions. In such a case, the forging method is a good choice. Thus, by convention, an ingot is initially cold forged to a given height, further cold forged to a thickness that permits rolling, and then is cold rolled to a desired thickness. Needless to say, cold rolling alone may be used if the ingot has a height and thickness within the ranges that allow cold rolling. Alternatively, cold forging may be used as the only means of working as long as care is taken to maintain a constant rate of working.

When a sufficient amount of working is applied in biaxial or more multiaxial directions to attain desired grain refinement, the ingot would crack. To avoid this ingot cracking, it is only necessary to carry out a heat treatment during the course of cold working so as to remove strains from the ingot. Following this, uniaxial cold working, preferably cold rolling, is conducted to apply a sufficient amount of working to attain grain refinement, and then a heat treatment is done under the optimum conditions as mentioned above, whereby a desired fine crystal grain target can be obtained.

If Ta comes in contact with oxygen at the temperature for the above heat treatment, oxygen would rapidly diffuse inside and raise the oxygen concentration in the target, resulting in an increase in the number of particles. The heat treatment, therefore, should be carried out in a way such that the contact with oxygen is minimized, e.g., in a vacuum.

Since the sputtering efficiency varies with the crystalline orientations of targets, the orientation alignment of the sputtered surface is also important. Aligning the orientation distribution in the target surface permits maintenance of the film quality uniformity in the film-deposited wafer. The deposition rate of a target is improved over that of a randomly oriented target when the orientation of the former is controlled so that the sum of the area ratios to the sputtered surface of the three planes {110}, {200}, and {211} of high atomic density is 55% or more. Also the uniformity of film quality in a wafer is maintained by restricting the dispersion of the sum of the area ratios of the these three planes in the target surface within ± 20%.

During the "burn-in" of a fresh target at the outset of its use, or after a TaN film has been deposited on a predetermined number of wafers, it is common to perform the deposition of a Ta film, or a process known as "pasting" to prevent the separation of the TaN film from the components and surrounding walls of the sputtering apparatus that could lead to the formation of particles. (Pasting is a process whereby normal sputtering in an Ar atmosphere is interposed between N₂ reactive sputtering runs. Generally a nitride film easily comes off while a metallic film is sticky, and coating a TaN film with Ta prevents the later separation of the TaN film and the division of the film into particles. Since the manner in which the metallic film is used to keep the TaN film in place is like to pasting, this is called "pasting" and is a kind of maintenance.) When the Ta film contains hydrogen atoms, high stresses in the film tend to force the Ta/TaN film to peel off from the components and surrounding walls of the sputtering apparatus, increasing the number of particles on the wafer. When the hydrogen concentration in the target is reduced to 20 ppm or below, the number of particles is diminished to a level no longer objectionable for practical purposes.

The number of particles is large in the early stage of the use of a target, while the surface portion damaged by mechanical finishing is being sputtered. It is for this reason that a process known as "burn-in" which removes the damaged surface layer is used. A thick damaged surface layer calls for a longer duration of burn-in. To enhance the efficiency of an LSI manufacturing process, it is necessary that the damaged surface layer is reduced accompanied with the control of initial particle generation.

In the case of a Ta target, decreasing the average roughness (Ra) of a finished surface by mechanical grinding renders it possible to diminish the damaged surface layer too. Grinding the damaged surface layer to an average roughness (Ra) of 0.01-5 µm makes it thin enough for practical use. Further reduction of Ra to less than 0.01 µm raises the machining cost but does not bring a corresponding merit because, while the damaged surface layer becomes thinner, the naturally oxidized film gains a dominant effect upon the number of particles.

The presence of an oxide layer on the surface of a target in the early stage of its use would cause abnormal discharge and an increase in the number of particles. In the case of a Ta target, when the oxide layer can be reduced to 200 nm or less thick, desirably to 20 nm or less thick, by chemical polishing after the mechanical grinding, the abnormal discharge is decreased with the decrease of the number of particles.

During the course of sputtering, the portions of the target other than the portion being eroded allow the deposition of a Ta layer or TaN layer (the film thus formed being called "re-deposited film). As the film thickens beyond a certain thickness, it comes off, forming particles. Roughening by sandblasting, etching, or the like of the non-eroded surface portions of a Ta target including a backing plate (i.e., a target assembly) that are exposed in a sputtering chamber, produces an anchoring effect which makes a re-deposited film more adherent and thereby decreases the number of particles.

When sputtering with a high power output to raise the deposition rate, it sometimes occurs that the temperature exceeds the melting point of the brazing filler metal between the target and backing plate that make up a target assembly or the surface temperature of the target increases beyond the Ta recovery temperature or recrystallization temperature to alter the target texture or structure. A Ta target assembly can be made resistant to such elevated temperatures when the target and backing plate are bonded by a metallic bond, e.g., by the diffusion bonding technique. The alteration of the target texture or structure can be prevented by the use of a backing plate made of an Al alloy, Cu, or Cu alloy that has adequate strength and good thermal conductivity.

### [EXAMPLES]

### (Example 1)

A Ta ingot made by electron-beam melting (hereinafter called EB ingot)(130 mm dia. and 60 mm high) was subjected to cold compressing forging to 100 mm dia. and 100 mm high and then was upset by cold forging to 160 mm dia. and 40 mm thick. The workpiece was heated at a heating rate of 15 °C/min, heat treated in a vacuum at 1200 °C for 2 hours, and then cold rolled to a thickness of 10 mm. It was again heated at a heating rate of 15 °C/min, heat treated in a vacuum at 1000 °C for 2 hours, and then machined to the shape of a target. The target so obtained had an average grain size of 150 µm in the center and an average grain size of 130 µm in the peripheral region about 12 cm distant from the center.

Analytical values of impurities it contained were: O: 20 ppm; H: 30 ppm; Na: <0.01 ppm; K: <0.01 ppm; U: <0.01 ppb; Th: <0.01 ppb; Fe: 0.01 ppm; Cr: < 0.1 ppm; and Ni: <0.1 ppm. Refractory elements contained were: Hf: 1 ppm; Nb: 10 ppm; Mo: 1 ppm; W: 3 ppm; Ti: <0.1 ppm; and Zr: 3 ppm; the total being 18 ppm. The sum of the intensity ratios of the three planes {110}, {200}, and {211} was 61%.

Sputtering was carried out using this target, and the number of particles found on a 6 in.-diameter wafer was counted. Particles 0.2 µm or larger in diameter numbered 52 at the outset of sputtering and 30 until the power output reached 300 kWh. The resistivity of the Ta film was 270 µΩcm, the dispersion in the wafer was 3σ = 4.5%, and the barrier characteristics were good.

### (Example 2)

A target was made following the process of Example 1 from an EB ingot of Ta having a hydrogen concentration of 15 ppm. Analytical values of its impurity contents were: O: 25 ppm; Na: <0.01 ppm; K: <0.01 ppm; U: <0.01 ppb; Th: <0.01 ppb; Fe: 0.01 ppm; Cr: <0.1 ppm; Ni: <0.1 ppm; Hf: 2 ppm; Nb: 9 ppm; Mo: 1 ppm; W: 4 ppm; Ti: <0.1 ppm; and Zr: 1 ppm. The target had an average grain size of 150 µm in the center and an average grain size of 135 µm in the peripheral region about 12 cm distant from the center. The sum of the intensity ratios of the three planes {110}, {200}, and {211} was 60%.

Sputtering was carried out using this target, with several runs of Ta pasting, and the number of particles found on a 6 in.-diameter wafer at the point the power output reached 300 kWh was counted. Particles 0.2 µm or larger in diameter numbered 20. (By way of comparison, the number of particles counted at the point of sputtering up to 300 kWh with the target of Example 1 (H: 30 ppm) was 30.) The barrier characteristics were good.

### (Example 3)

The surface portion of a target to be sputtered that had been machined similarly to Example 2 (Ra = 15 µm) was mechanically polished to Ra = 0.3 µm.

The target was used in sputtering, and the number of particles found on a 6 in.-diameter wafer in the early stage of sputtering was counted. Particles 0. 2 µm or larger in diameter numbered 30 (as compared with 52 at the same stage of sputtering with the target of Example 2) and 16 when sputtered up to 300 kWh.

### (Example 4)

A target mechanically polished like that of Example 3 was further polished chemically to remove an oxide layer from the surface. The Ra of the target surface was 0.03 µm. A depth analysis with an Auger electron analyzer showed that the thickness of the oxide layer was 15 nm whereas that of the target of Example 3 was 100 nm (250 nm in Example 6).

This target was used in sputtering and the number of particles on a 6 in.-diameter wafer in the early stage of sputtering was counted. Particles 0.2 µm or larger in diameter numbered 26 and after sputtering up to 300 kWh numbered 13.

### (Example 5)

The target of Example 2 was roughened on the surface by sandblasting in the portions such as the side faces where re-deposition would take place. During sputtering with this target, the number of particles on a 6 in.-diameter wafer was counted. Particles 0.2 µm or larger in diameter numbered 52 initially and 14 upon sputtering to 300 kWh.

### (Example 6)

The target of Example 2 was bonded to a backing plate of an Al alloy (A5052) by the diffusion bonding technique (at a bonding temperature of 300-650 °C ).

With this target, a cycle of sputtering for 30 seconds at a sputtering power density of 10 W/cm² and an interruption for 90 seconds was repeated 30 times, and the grain size of the target was measured. The original size of 150 µm remained unchanged. The number of particles was 38 in the early stage of sputtering and 18 when sputtered up to 300 kWh.

### (Comparative Example 1)

An ingot of the same lot as for the target of Example 2 was cut into a size of 130 mm in dia. and 60 mm high. Without going through cold forging for compression, the workpiece was directly cold forged for upsetting to 160 mm in dia. and 40 mm thick. It was heat treated in a vacuum at 1200 °C for 2 hours and was cold upset to a disk 10 mm thick. After a further heat treatment in a vacuum at 1200 °C for 2 hours, it was machined to a target shape. This target had a structure such that fine crystals were contained in coarse crystals of about 10-20 mm.

The target had an average grain size of 500 µm in the center and an average grain size of 300 µm in the peripheral region about 12 cm distant from the center. The sum of the intensity ratios of the three planes {110}, {200} and {211} was 59%.

Sputtering was carried out using this target, and the number of particles found on a 6 in.-diameter wafer was counted. Particles 0.2 µm or larger in diameter numbered 80 in the early stage and 50 up to 300 kWh. The resistivity of the Ta film was 260 µΩcm, and the dispersion in the wafer was 3σ = 8.5%.

### (Comparative Example 2)

A Ta target (O: 80 ppm; Na: <0.01 ppm; K: <0.01 ppm; U: <0.01 ppb; Th: <0.0 1 ppb; Fe: 0.01 ppm; Cr: <0.1 ppm; Ni: <0.1 ppm; Hf: 1 ppm; Nb: 15 ppm; Mo: 3 ppm; W: 3 ppm; Ti: 1.5 ppm; and Zr: 5 ppm, the total of refractory metal elements being 27 ppm) was cut into a piece 130 mm in dia. and 60 mm high. From it a target was made in the manner described in Example 1. The target had an average grain size of 15 µm in the center and an average grain size of 130 µm in the peripheral region about 12 cm distant from the center. The sum of the intensity ratios of the three planes {110}, {200}, and {211} was 58%.

Sputtering with this target produced particles on a 6 in.-diameter wafer. The number of particles 0.2 µm or larger in diameter in the early stage of sputtering was 78 and at the point the power output reached 300 kWh was 50. The resistivity of the Ta film was 350 µΩcm, and the dispersion in the wafer was 3σ = 4.8%.

### (Comparative Example 3)

An ingot of the same lot as for the target of Example 2 was cut into a size of 130 mm in dia. and 60 mm high. The workpiece was cold forged for compression to 100 mm in dia. and 100 mm high and then cold forged for upsetting to 160 mm dia. and 40 mm thick. Upon cold rolling to a thickness of 30 mm it began cracking from the side faces, and no more working was possible.

### (Comparative Example 4)

An ingot of the same lot as for the target of Example 2 was cut into a size of 130 mm in dia. and 60 mm high, cold forged for compression to 112 mm in dia. and 80 mm high, and then cold forged for upsetting to 160 mm in dia. and 40 mm thick. It was cold rolled and the rolling was interrupted at the point the workpiece attained a thickness of 20 mm. It was then heated at a heating rate of 15 °C/min and heat treated in a vacuum at 1000 °C for 2 hours, and was machined to a target shape. The target had an average grain size of 100 µm in the center and an average grain size of 500 µm in the peripheral region about 12 cm distant from the center. The sum of the intensity ratios of the three planes {110}, {200} and {211} was 50%.

Sputtering was carried out using this target, and the number of particles found on a 6 in.-diameter wafer was counted. Particles 0.2 µm or larger in diameter numbered 55 in the early stage and 42 up to 300 kWh. The resistivity of the Ta film was 260 µΩcm, and the dispersion in the wafer was 3σ = 8%.

The data of Examples and Comparative Examples are summarized in Table 1.

### [ADVANTAGES OF THE INVENTION]

The use of a Ta sputtering target according to this invention makes it possible to obtain a Ta film and a TaNₓ (x = 0.5-1.3) film with a smaller number of objectionable particles and with less dispersion of resistivity values than heretofore. The target can be made without the need of a special wet refining process which, from an industrial viewpoint, is disadvantageous in respect of cost.

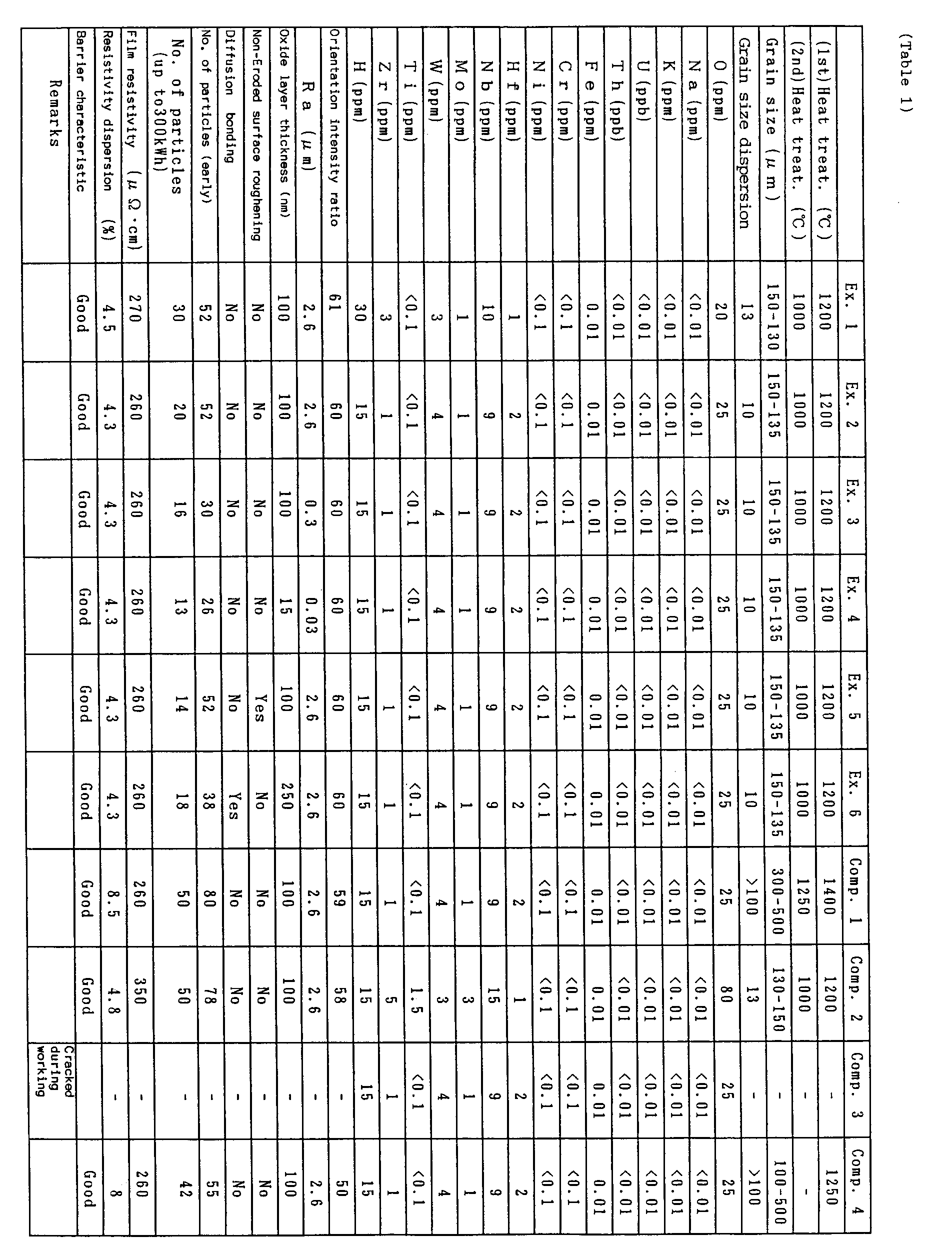

## Claims

1. A Ta sputtering target wherein (a) an average grain size is in the range of 0.1-300 µm, with locational dispersion of the average grain size within ± 20%, (b) an oxygen concentration is 50 ppm or below, and (c) impurity concentrations are such that Na≦ 0.1 ppm, K≦ 0.1 ppm, U≦ 1 ppb, Th≦ 1 ppb, Fe≦ 5 ppm, Cr≦ 5 ppm, and Ni≦ 5 ppm, the total content of refractory metal elements (Hf, Nb, Mo, W, Ti and Zr) being 50 ppm or less.

2. A Ta sputtering target of claim 1 wherein the sum of the intensity ratios of the three planes {110}, {200} and {211} is 55% or more and the locational dispersion of the sum of the intensity ratios of the three planes is 20% or less.

3. A Ta sputtering target of claim 1 or 2 wherein hydrogen concentration is 20 ppm or less.

4. A Ta sputtering target of claim 1 or 2 wherein the average roughness (Ra) of the surface portion to be sputtered is 0.01-5 µm.

5. A Ta sputtering target of claim 3 wherein the average roughness (Ra) of the surface portion to be sputtered is 0.01-5 µm.

6. A Ta sputtering target of claim 1 or 2 wherein the surface portion to be sputtered has an oxide layer with a thickness of 200 nm or less.

7. A Ta sputtering target of claim 3 wherein the surface portion to be sputtered has an oxide layer with a thickness of 200 nm or less.

8. A Ta sputtering target of claim 4 wherein the surface portion to be sputtered has an oxide layer with a thickness of 200 nm or less.

9. A Ta sputtering target of claim 5 wherein the surface portion to be sputtered has an oxide layer with a thickness of 200 nm or less.

10. A Ta sputtering target of claim 1 or 2 wherein the non-eroded surface portions of a target where a film is formed by the deposition of the sputtered target material is roughened.

11. A Ta sputtering target of claim 3 wherein the non-eroded surface portions of a target where a film is formed by the deposition of the sputtered target material is roughened.

12. A Ta sputtering target of claim 4 wherein the non-eroded surface portions of a target where a film is formed by the deposition of the sputtered target material is roughened.

13. A Ta sputtering target of claim 5 wherein the non-eroded surface portions of a target where a film is formed by the deposition of the sputtered target material is roughened.

14. A Ta sputtering target of claim 6 wherein the non-eroded surface portions of a target where a film is formed by the deposition of the sputtered target material is roughened.

15. A method of manufacturing a Ta sputtering target of claim 1 comprising making a Ta ingot which has an oxygen concentration of 50 ppm or below and impurity concentrations such that Na≦ 0.1 ppm, K≦ 0.1 ppm, U≦ 1 ppb, Th ≦ 1 ppb, Fe≦ 5 ppm, Cr≦ 5 ppm and Ni≦ 5 ppm, the total content of refractory metal elements (Hf, Nb, Mo, W, Ti and Zr) being 50 ppm or less, working the ingot by cold forging or/and cold rolling, and finally machining the workpiece obtained to a target, wherein in the course of working of the cold forging or/and cold rolling, the workpiece is heat treated in a vacuum at a heating rate of at least 10 °C/min and at a holding temperature of 800-1200 °C whereby the material attains an average grain size of 0.1-300 µm with locational dispersion within ± 20%.

16. A Ta sputtering target assembly comprising a Ta sputtering target of anyone of claim 1 to 14 and a backing plate bonded to the target.

17. An assembly according to claim 16 wherein the portion of the backing plate where the sputtered material is to deposit and form a film thereon is roughened on the surface.

18. An assembly according to claim 16 wherein the Ta sputtering target and the backing plate are bonded by a metallic bond.

19. An assembly according to claim 17 wherein the Ta sputtering target and the backing plate are bonded by a metallic bond.
